Europäisches Patentamt

European Patent Office

Office européen des brevets

(19)

(11) Publication number: **0 198 468 B1**

# EUROPEAN PATENT SPECIFICATION

(12)

(45) Date of publication of patent specification: 23.10.91   (51) Int. Cl.5: **H01L 27/02, H01L 29/06**

(21) Application number: 86105169.6

(22) Date of filing: 15.04.86

(54) Protective device for integrated circuit.

(30) Priority: 15.04.85 JP 79645/85

(43) Date of publication of application:
22.10.86 Bulletin 86/43

(45) Publication of the grant of the patent:
23.10.91 Bulletin 91/43

(84) Designated Contracting States:
DE FR GB

(56) References cited:
EP-A- 0 102 696
DE-A- 2 443 304

MICROELECTRONICS AND RELIABILITY, vol.
22, no. 2, 1982,pages 187-193, Pergamon
Press LTD, Oxford, GB; C.A.MILLER et al.:
"Punch-through gate protection of M.O.S.
devices"

PATENTS ABSTRACTS OF JAPAN, vol. 7, no.
136 (E-181)[1281], 14th June 1983; & JP-A-58
51 555

IEEE-11th ANNUAL PROCEEDINGS RELIABIL-
ITY PHYSICS, Las Vegas, 3th-5th April 1973,
pages 198-202, IEEE, New York, US;
L.W.LINHOLM et al.: "Electrostatic gate pro-

tection using an arc gap device"

IEEE Transactions on electron devices, vol.
ED-25, no. 8, August 1978, pages 926-932,
IEEE, New York, US; S.H.COHEN et al.: "An
improved input protection circuit for C-
Mos/SOS arrays"

(73) Proprietor: NEC CORPORATION
7-1, Shiba 5-chome Minato-ku
Tokyo 108-01(JP)

(72) Inventor: Fujii, Takeo
c/o NEC Corporation 33-1, Shiba 5-chome
Minato-ku Tokyo(JP)

(74) Representative: Glawe, Delfs, Moll & Partner
Patentanwälte
Postfach 26 01 62 Liebherrstrasse 20
W-8000 München 26(DE)

## Description

The present invention relates to a protective device for an integrated circuit according to the preamble part of claim 1.

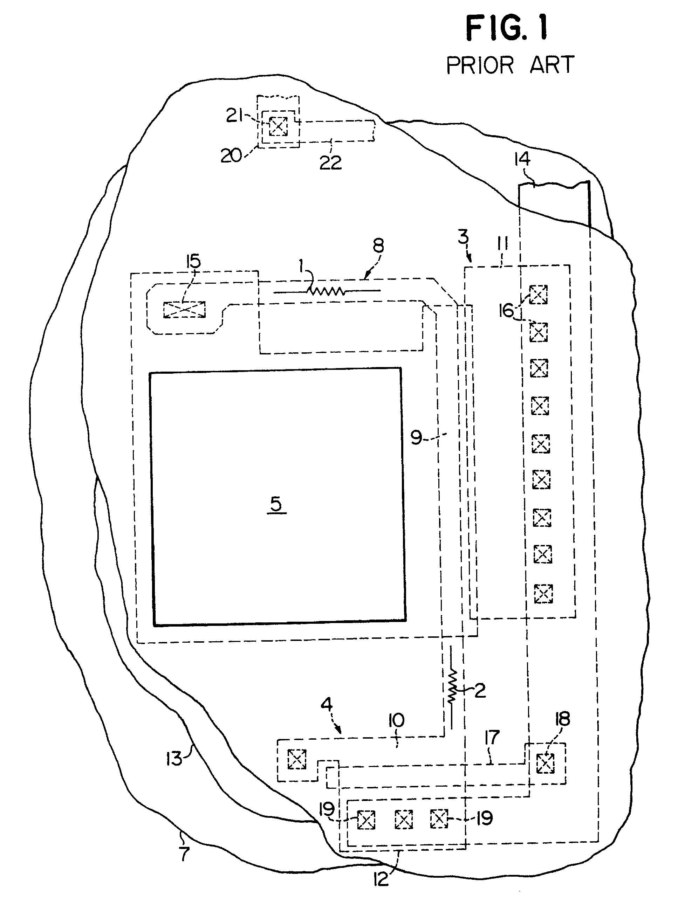

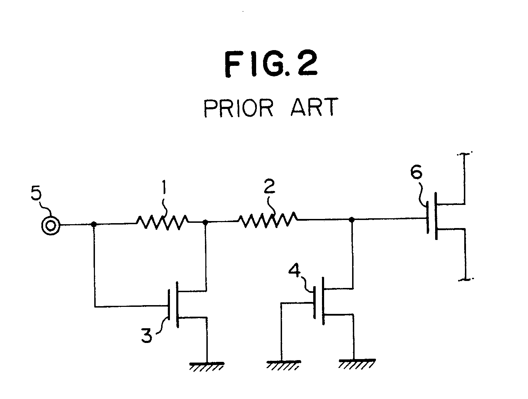

A typical example of a known protective device for an integrated circuit is illustrated in Figs. 1 and 2. The known protective device comprises two resistors 1 and 2 and two MOS transistors 3 and 4. The resistors 1 and 2 are connected in series and provided between a bonding pad 5 of aluminium and a gate electrode of a MOS transistor 6 which form part of the integrated circuit fabricated on a p-type silicon substrate 7.

In the silicon substrate 7 an n-type impurity region 8 is formed which provides drain regions 9 and 10 of the MOS transistors 3 and 4 and the resistors 1 and 2. The silicon substrate 7 further has n-type impurity regions which provide respective source regions 11 and 12 of the MOS transistors 3 and 4. On the surface of the substrate 7 is thermally grown a silicon dioxide 13 providing gate oxide films for the MOS transistors 3 and 4 and a thick oxide on which the bonding pad 5 and a conductive layer 14 of aluminium are formed. Though not shown in the drawings, the bonding pad 5 is electrically connected to a pin through a bonding wire for propagation of signals from the pin to the MOS transistor 6. On the other hand, the conductive layer 14 is electrically connected to a ground pin (not shown) so as to supply the integrated circuit with the ground voltage.

The n-type impurity region 8 partly underlies the bonding pad 5 and is electrically connected to the bonding pad 5 by a contact 15 which passes through the thick oxide. The bonding pad 5 extends on the gate oxide film of the MOS transistor 3 for providing the gate electrode of the MOS transistor 3. The source region 11 also partly underlies the conductive layer 14 and is electrically connected to the conductive layer 14 by a plurality of contacts 16 each passing through the thick oxide. The gate oxide film of the MOS transistor 3 has a thickness of about 600 nm (6000 Å) so that the MOS transistor 3 turns on under application of an excess voltage higher than about 20 V, thereby discharging the excess voltages to the ground.

On the gate oxide film of the MOS transistor 4 extends a gate electrode 17 of the MOS transistor 4 which is electrically connected to the conductive layer 14 by a contact 18 passing through the thick oxide. The source region 12 is also electrically connected to the conductive layer 14 by a plurality of contacts 19 each passing through the thick oxide. The gate oxide film has a thickness of about 20 to 30 nm (200 to 300 Å) approximately equal to those of the MOS transistor 6 and other transistors (not shown) forming parts of the integrated circuit.

The MOS transistor 4 thus arranged functions as a punch-through type transistor so that a depletion layer extends and bridges between the drain and the source regions 10 and 12 under the excess voltage, thereby discharging the excess voltage to the ground.

Under recent development of integrated circuit fabrication techniques extremely thin gate oxide films are employed which are liable to be damaged by a relatively low excess voltage. This means that the protection circuit should promptly respond to the excess voltage and forcibly lower the voltage level at the gate electrode of the MOS transistor 6. Experiences to the prior art teach us that high junction leakage currents are not observed after application of an excess voltage five times to the bonding pad 5. The excess voltage is supplied from a capacitor with a capacitance value of 100 pF through a resistance of 1.5 kΩ after charging the capacitor to 2000 V.

However, the effectiveness of this prior art protective device depends on the circuit layout of the integrated circuit fabricated on the same substrate. The protective device has a resistor 1 located between the bonding pad 5 and the MOS transistor 3. When an excess high voltage is applied to the bonding pad 5, the impurity region 8 adjacent to the contact 15 is liable to breakdown. If the substrate 7 has an impurity region 20 with a different voltage level in the vicinity of the contact 15, the leakage current concentrates in a limited area of the impurity region 20, thereby causing the temperature of the substrate 7 around the electric path to rapidly rise. This high temperature results in the destruction of the pn junction and short-circuits aluminium leads running over the pyrogen due to the softening thereof. Moreover, when the impurity region 8 is forwardly biased under a surge current, the excess voltage reaches the pn junction formed between the substrate 7 and the impurity region 20 and destroys the pn junction. Especially, if the impurity region 20 has a small area with only one contact 21 connecting the region 20 to an above conductive layer 22, the influence of the destruction is extremely serious.

Another disadvantage of the prior art is related to the resistors 1 and 2. The resistors 1 and 2 allow reduction of the undesirable excess voltage level, however the resistors 1 and 2 do not allow signals to propagate at high speed.

An input protective device according to the preamble part of claim 1 is disclosed in "Microelectronics and Reliability", Vol.22, No.2, 1982, pp. 182-193, C.A. Miller at all "Punch-Through Gate Protection of M.O.S. Devices". In this known device input protection is performed by using a punch-through transistor, however, an impurity region is directly contacted with an aluminium wiring. In this configuration, alloy spikes are produced upon application of an abnormal current due to direct contact between the aluminium wiring and the impurity region.

From EP-A-0 102 696 a device is known in which a polycrystalline silicon electrode of a capacitor of a memory cell is biased with an aluminium wiring and coupled through a diode to a substrate for restricting voltage rise at the upper electrode. The restriction in voltage level results in preventing an insulating film on the electrode from destruction. However, a barrier against alloy spikes is not disclosed.

It is therefore an object of the invention to provide a protective device which can hardly be damaged by an abnormal voltage and which allows signals to propagate at high speed.

This object is achieved by a protective device for an integrated circuit fabricated on a semiconductor substrate of a first conductivity type comprising:

an external signal plate receiving an external signal; a reference voltage plate receiving a reference voltage; first and second impurity regions of a second conductivity type formed in a surface portion of said semiconductor substrate and having a rectangular shape elongated in a longitudinal direction, said first and second impurity regions being spaced apart from each other in parallel along the longitudinal dircetion;

an insulating layer covering the surface portion and formed with first and second contact holes said first and second contact holes being formed in rectangular patterns extending in the longitudinal direction above said first and second impurity regions, respectively;

first means for electrically connecting the external signal plate to the first impurity region through the first contact hole; and

second means for electrically connecting said reference voltage plate to the second impurity region through the second contact hole said first impurity region being electrically isolated from the second impurity region when the external signal is within a normal voltage range, a current path being established between the first and second impurity regions when said external signal is outside said normal voltage range, wherein said first means includes a first intermediate layer of polycrystalline silicon having a rectangular shape elongated in the longitudinal direction, a first longitudinal periphery portion contacted with said first impurity region through the first contact hole and a second longitudinal periphery portion opposite to the first longitudinal periphery portion, and third contact hole formed in a rectangular pattern elongated in the longitudinal direction above the second periphery portion in the insulating layer covering the first intermediate layer, said external signal plate being contacted with the second periphery portion through the third contact hole, and wherein said second means includes a second intermediate layer of polycrystalline silicon having a rectangular shape elongated in the longitudinal direction, a third longitudinal periphery portion contacted with said second impurity region through the second contact hole and a fourth longitudinal periphery portion, and a fourth contact hole formed in a rectangular pattern elongated in the longitudinal direction above the fourth periphery portion in the insulating layer covering the second intermediate layer, said reference voltage plate being contacted with the fourth periphery portion through the fourth contact holes, wherein the first to fourth contact holes have substantially the same length in the longitudinal direction.

The features and advantages of the protective device according to the present invention will be more clearly appreciated from the following description taken in conjunction with the accompanying drawings in which:

Fig. 1 is a partially cut-away plan view showing a typical example of a known protective device;

Fig. 2 is a circuit diagram of the protective device illustrated in Fig. 1;

Fig. 3 is a plan view shoving an embodiment of the protective device according to the present invention;

Fig. 4 is a fragmentary sectional view taken along the line A-A of Fig. 3; and

Fig. 5 is a plan view showing a layout arrangement of the protective device and a MOS transistor forming part of an integrated circuit fabricated on the same substrate.

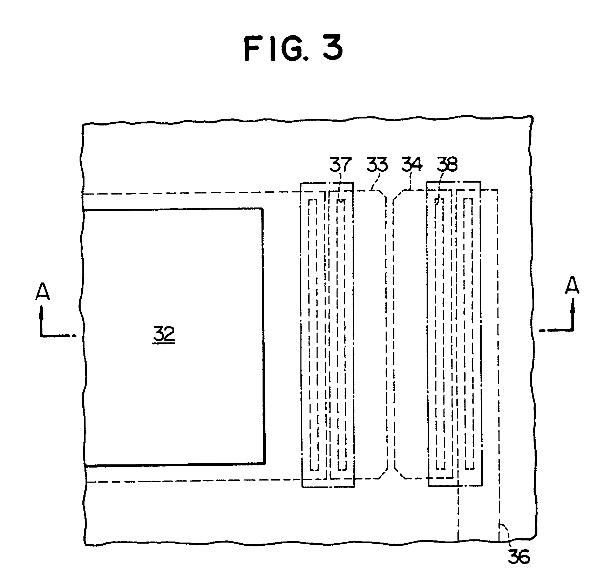

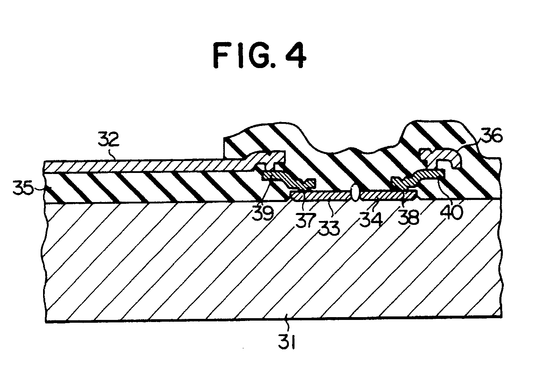

Referring to Figs. 3 and 4 of the drawings, there is shown a protective device implemented on a p type silicon substrate 31 together with an integrated circuit ( not shown ) to which signals are applied through a bonding pad 32 of alunimium. When the integrated circuit has the same construction as that shown in Fig. 2, the signals are propagated from the bonding pad 32 to a gate electrode of a MOS transistor corresponding to the MOS transistor 6. In the surface portion of the silicon substrate 31 are formed n type impurity regions 33 and 34 extending substantially in parallel to and at spacings from each other. In the embodiment herein shown, the impurity regions 33 and 34 are about 120 $\mu$m (microns) in length and have generally rectangular upper surfaces. The impurity region 33 is about 4 $\mu$m (microns) away from the impurity region 34.

The surface of the silicon substrate 31 is covered with a thick insulating layer 35 of silicon oxide on which the bonding pad 32 is located. Though not shown in the drawings, the bonding pad 32 is connected to a bonding wire which in turn is electrically connected to a signal pin outwardly extending from a package that houses the silicon substrate 31. On the thick insulating layer 35 is also formed a conductive layer 36 of aluminium electrically connected at one end thereof to a ground pin ( not shown ) outwardly extending from the package. In this embodiment, the conductive layer 36 is supplied with the ground voltage, however, it is possible to apply a different constant voltage to the conductive layer 36.

The thick insulating layer 35 is provided with contact holes 37 and 38 each having generally rectangular openings at both ends thereof. The rectangular openings extend in directions substantially in parallel to the extending directions of the impurity regions 33 and 34. The contact holes 37 and 38 are filled with polysilicon heavily doped with phosphorus which provides contact layers 39 and 40 with low resistance. The contact layer 39 has contact areas at the lower and upper ends thereof one of which is connected to the bonding pad 32 and the other of which is connected to the impurity region 33 for providing an electric path between the bonding pad 32 and the impurity region 33. Similarly, the contact layer 40 has contact areas at the lower and upper ends thereof one of which is connected to the impurity region 34 and the other of which is connected to the conductive layer 36, thereby providing an electric path from the impurity region 34 to the conductive layer 36. The contact layers 39 and 40 are formed into configurations dictated by the configurations of the contact holes 37 and 38 so that each contact area of the contact layers 39 and 40 extends in a direction substantially in parallel to the extending directions of the impurity regions 33 and 34. With contact areas of the contact layer 39 being thus arranged, a given voltage applied to the bonding pad 32 is uniformly propagated to the impurity region 33 through the contact layer 39. Moreover, as can be seen from Figs. 3 and 4, the bonding pad 32 has a side edge extending in parallel to the side line of the upper surface of the impurity region 33, so that the given voltage applied to the bonding pad 32 uniformly influences an electric field created in the impurity region 33. In the similar manner, the ground voltage applied to the conductive layer 36 is uniformly propagated to the impurity region 34. The conductive layer 36 has a side edge extending substantially in parallel to the side line of the upper surface of the impurity region 34, so that a uniform electric field is also created in the impurity region 34. The uniform electric fields prevent the pn junctions between the impurity regions 33 and 34 and the substrate 31 from early breakdowns.

In this embodiment, the contact layers 39 and 40 have a length of about 10 $\mu$m (microns) so that

the bonding pad 32 is sidewardly and upwardly spaced from the impurity region 33. This arrangement prevents the bonding pad 32 and impurity region 33 from a short-circuit caused by melting aluminium under the application of the excess voltage.

On the thick insulating layer 35 is deposited a passivation layer 41 of silicon oxide which fully covers the conductive layer 36. The bonding pad 32 is partially covered with the passivation layer 41 and is in part exposed for wire bonding.

In operation, when an excess voltage is applied to the bonding pad 32, the excess voltage propagates through the contact layer 39 to the impurity region 33. The impurity regions 33 and 34 are spaced apart at the very narrow interval, so that the impurity region 33 short-circuits to the impurity region 34, thereby discharging the excess voltage to the ground.

In the embodiment shown in Figs. 3 and 4, the impurity region 33 is spaced apart from the impurity region 34 at the interval of about 4 $\mu$m (microns). However, the interval can be narrower than 4 $\mu$m (microns) when the integrated circuit should be very sensitive to excess voltage. Similarly, the contact layer 39 may have a length greater than about 10 $\mu$m (microns) depending upon the locations of the impurity region 33 and the bonding pad 32.

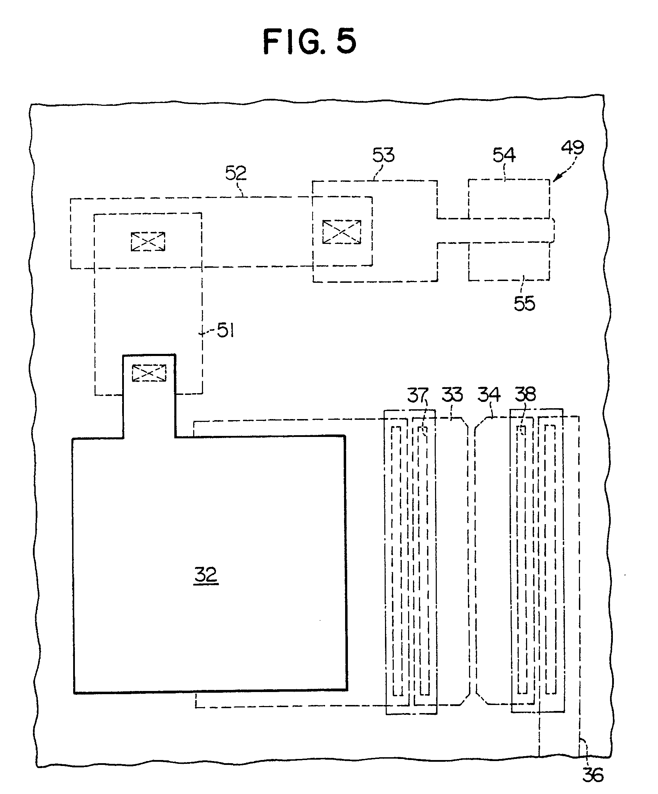

Fig. 5 shows a layout arrangement of the protective device and a MOS transistor 49 which forms part of the integrated circuit fabricated on the same substrate 31. The substrate 31 further has an n type impurity region 51 which is electrically connected to the bonding pad 32 by a contact layer passing through the thick insulating layer 35. The n type impurity region 51 is in turn connected to a conductive layer 52 of aluminium through a contact layer. A polysilicon layer 53 partially underlies the conductive layer 52 for providing an electrical connection through a contact layer. The polysilicon layer 53 has a narrow portion extending on a gate oxide of the MOS transistor 49 and provides the gate electrode therefor. The substrate 31 further has n type impurity regions 54 and 55 for providing source and drain of the MOS transistor 49. The bonding pad 32 is thus electrically connected to the gate electrode of the MOS transistor 49 forming part of the integrated circuit, the signals are propagated from the bonding pad 32 to the MOS transistor 49.

As will be understood from the foregoing description, the protective device according to the present invention is provided with the impurity region 34 spaced apart from the impurity region 33 at the narrow interval such as 4 $\mu$m (microns) so that the excess voltage is discharged to the impurity region 34 regardless of existence of another impurity region which forms part of a circuit element of the integrated circuit fabricated on the same substrate 31. This means that a designer can employ closely packed bonding pads and a circuit layout in which bonding pads are arranged to be in the vicinity of a memory cell array or a decoder circuit which inherently need a number of small contact areas.

Moreover, the protective device according to the present invention does not include resistors in the propagation path for signals, so that the propagation delay is clearly improved.

## Claims

1. A protective device for an integrated circuit fabricated on a semiconductor substrate (31) of a first conductivity type comprising:
   an external signal plate (32) receiving an external signal; a reference voltage plate (36) receiving a reference voltage;
   first and second impurity regions (33, 34) of a second conductivity type formed in a surface portion of said semiconductor substrate (31) and having a rectangular shape elongated in a longitudinal direction, said first and second impurity regions being spaced apart from each other in parallel along the longitudinal direction;
   an insulating layer (35) covering the surface portion and formed with first and second contact holes (37, 38), said first and second contact holes (37, 38) being formed in rectangular patterns extending in the longitudinal direction above said first and second impurity regions, respectively;
   first means for electrically connecting the external signal plate (32) to the first impurity region (33) through the first contact hole (37); and
   second means for electrically connecting said reference voltage plate (36) to the second impurity region (34) through the second contact hole (38), said first impurity region (33) being electrically isolated from the second impurity region (34) when the external signal is within a normal voltage range, a current path being established between the first and second impurity regions (33, 34) when said external signal is outside said normal voltage range, **characterized** in that said first means includes a first intermediate layer (39) of polycrystalline silicon having a rectangular shape elongated in the longitudinal direction, a first longitudinal periphery portion contacted with said first impurity region (33) through the first contact hole (37) and a second longitudinal periphery portion opposite to the first longitudinal periphery portion, and third contact hole formed in a rectangular pattern elongated in the longitudinal direction above the second periphery portion in the insulating layer covering the first intermediate layer, said external signal plate (32) being contacted with the second periphery portion through the third contact hole, and in that said second means includes a second intermediate layer (40) of polycrystalline silicon having a rectangular shape elongated in the longitudinal direction, a third longitudinal periphery portion contacted with said second impurity region through the second contact hole (38) and a fourth longitudinal periphery portion, and a fourth contact hole formed in a rectangular pattern elongated in the longitudinal direction above the fourth periphery portion in the insulating layer covering the second intermediate layer, said reference voltage plate (36) being contacted with the fourth periphery portion through the fourth contact holes, wherein the first to fourth contact holes have substantially the same length in the longitudinal direction.

2. A protective device as set forth in claim 1, in which said first and second impurity regions (33, 34) are spaced apart at an interval equal to or less than about 4 $\mu$m.

3. A protective device as set forth in claim 1, in which said external signal plate (32) is formed of aluminium and in which said first intermediate layer (39) is formed of a heavily doped polycrystalline silicon.

## Revendications

1. Dispositif de protection pour un circuit intégré fabriqué sur un substrat de semi-conducteur (31) d'un premier type de conductivité comprenant :
   une plaque de signal externe (32) recevant un signal externe ;
   une plaque de tension de référence (35) recevant une tension de référence ;
   des première et seconde régions d'impuretés (33, 34) d'un second type de conductivité formées dans une portion de surface du substrat de semi-conducteur (31) et présentant une forme rectangulaire allongée dans un sens longitudinal, les première et seconde régions d'impuretés étant séparées l'une de l'autre en parallèle suivant le sens longitudinal ;
   une couche isolante (35) recouvrant la portion de surface et formée avec des premier et second trous de contact (37, 38), les premier et second trous de contact (37, 38) étant formés en configuration rectangulaire s'étendant dans le sens longitudinal au-dessus desdites première et seconde régions d'impuretés, respectivement ;

un premier moyen pour connecter électriquement la plaque de signal externe (32) à la première région d'impuretés (33) à travers le premier trou de contact (37) ; et

un second moyen pour électriquement connecter la plaque de tension de référence (36) à la seconde région d'impuretés (34) à travers le second trou de contact (38), la première région d'impuretés (33) étant électriquement isolée de la seconde région d'impuretés (34) lorsque le signal externe est a l'intérieur d'une plage normale de tensions, un trajet de courant étant établi entre les première et seconde régions d'impuretés (33, 34) lorsque le signal externe est en dehors de la plage normale de tensions, caractérisé en ce que ledit premier moyen comporte une première couche intermédiaire (39) de silicium polycristallin comportant une forme rectangulaire allongée dans le sens longitudinal, une première portion de périphérie longitudinale mise en contact avec la première région d'impuretés (33) à travers le premier trou de contact (37) et une seconde portion de périphérie longitudinale opposée à la première portion de périphérie longitudinale, et un troisième trou de contact formé en une configuration rectangulaire allongée dans le sens longitudinal au-dessus de la seconde portion de périphérie dans la couche isolante recouvrant la première couche intermédiaire, la plaque de signal externe (32) étant mise en contact avec la seconde portion de périphérie à travers le troisième trou de contact, et en ce que le second moyen comporte une seconde couche intermédiaire (40) de silicium polycristallin présentant une forme rectangulaire allongée dans le sens longitudinal, une troisième portion de périphérie longitudinale mise en contact avec la seconde région d'impuretés à travers le second trou de contact (38) et une quatrième portion de périphérie longitudinale, et un quatrième trou de contact formé en une configuration rectangulaire allongée dans le sens longitudinal au-dessus de la quatrième portion de périphérie dans la couche isolante recouvrant la seconde couche intermédiaire, la plaque de tension de référence (36) étant mise en contact avec la quatrième portion de périphérie à travers les quatrièmes trous de contact, dans laquelle les premier au quatrième trous de contact ont pratiquement la même longueur dans le sens longitudinal.

2. Dispositif de protection selon la revendication 1, dans lequel les première et seconde régions d'impuretés (33, 34) sont séparées d'un intervalle égal ou inférieur à environ 4 μm.

3. Dispositif de protection selon la revendication 1, dans lequel la plaque de signal externe (32) est constituée d'aluminium et dans laquelle la première couche intermédiaire (39) est constituée d'un silicium polycristallin fortement dopé.

**Patentansprüche**

1. Schutzanordnung für eine integrierte Schaltung, die auf einem Halbleitersubstrat (31) eines ersten Leitungstyps hergestellt ist; mit einer externen Signalplatte (32), die ein externes Signal empfangt; einer Referenzspannungsplatte (36), die eine Referenzspannung empfängt; ersten und zweiten Fremdatombereichen (33, 34) eines zweiten Leitungstyps, die in einem Oberflächenteil des Halbleitersubstrats (31) gebildet sind und eine rechteckige Form aufweisen, die in einer Längsrichtung verlängert ist, wobei die ersten und zweiten Fremdatombereiche im Abstand zueinander parallel entlang der Längsrichtung angeordnet sind; einer Isolierschicht (35), die den Oberflächenteil abdeckt und mit ersten und zweiten Kontaktlöchern (37, 38) versehen ist, wobei die ersten und zweiten Kontaktlöcher (37, 38) in rechteckigen Mustern, die sich jeweils in Längsrichtung oberhalb der ersten und zweiten Fremdatombereiche erstrecken, ausgebildet sind; ersten Mitteln zum elektrischen Anschließen der externen Signalplatte (32) an den ersten Fremdatombereich (33) über das erste Kontaktloch (37); und zweiten Mitteln zum elektrischen Anschließen der Referenzspannungsplatte (36) an den zweiten Fremdatombereich (34) über das zweite Kontaktloch (38), wobei der erste Fremdatombereich (33) elektrisch vom zweiten Fremdatombereich (34) isoliert ist, wenn das externe Signal sich innerhalb eines normalen Spannungsbereiches befindet, wobei zwischen den ersten und zweiten Fremdatombereichen (33, 34) dann ein Strompfad errichtet wird, wenn das externe Signal außerhalb des normalen Spannungsbereiches liegt, dadurch **gekennzeichnet,** daß die ersten Mittel eine erste Zwischenschicht (39) aus polykristallinem Silizium aufweisen, die eine rechteckige Form hat, die in Längsrichtung verlängert ist, einen ersten langgestreckten peripheren Teil, der mit dem ersten Fremdatombereich (33) über das erste Kontaktloch (37) kontaktiert ist, und einen zweiten langgestreckten peripheren Teil gegenüber dem ersten langgestreckten peripheren Teil und ein drittes Kontaktloch, das in einem rechteckigen Muster ausgebildet ist, das sich in der Längsrichtung oberhalb des zweiten peripheren Teils in der Isolierschicht erstreckt, welche die erste Zwischenschicht abdeckt, wobei die externe Signalplatte (32) mit dem zweiten peripheren Teil über das dritte Kontaktloch kontaktiert ist; und

daß die zweiten Mittel eine zweite Zwischenschicht (40) aus polykristallinem Silizium aufweisen, die eine rechteckige Form hat, die in Längsrichtung verlängert ist, einen dritten langgestreckten peripheren Teil, der mit dem zweiten Fremdatombereich über das zweite Kontaktloch (38) kontaktiert ist, und einen vierten langgestreckten, peripheren Teil, und ein viertes Kontaktloch, das sich in einem rechteckigen Muster in Längsrichtung oberhalb des vierten peripheren Teils in der Isolierschicht, welche die zweite Zwischenschicht abdeckt, erstreckt, wobei die Referenzspannungsplatte (36) mit dem vierten peripheren Teil über das vierte Kontaktloch kontaktiert ist, wobei die ersten bis vierten Kontaktlöcher im wesentlichen die gleiche Länge in Längsrichtung aufweisen.

2. Schutzanordnung nach Anspruch 1, bei der die ersten und zweiten Fremdatombereiche (33, 34) zueinander einen Abstand von gleich oder weniger als $4\mu m$ einnehmen.

3. Schutzanordnung nach Anspruch 1, bei der die externe Signalplatte (32) aus Aluminium gebildet ist und bei der die erste Zwischenschicht (39) aus einem hochdotierten polykristallinen Silizium gebildet ist.

EP 0 198 468 B1

# FIG. 1
## PRIOR ART

8

# FIG.2
## PRIOR ART

# FIG. 3

# FIG. 4

EP 0 198 468 B1

# FIG. 5

12